# DEMANDE DE BREVET EUROPEEN

(11) **EP 2 466 743 A1**
(43) Date de publication de la demande: **20.06.2012**
(21) Numéro de dépôt: 11192435.3
(22) Date de dépôt: 07.12.2011
(51) Int. Cl.: H03B 15/00, H03L 7/07

(54) **Circuit oscillant à jonctions à effet de magnétorésistance géante**

(30) Priorité: 16.12.2010 FR 1060599
(71) Demandeur: Commissariat à l'Énergie Atomique et aux Énergies Alternatives, 75015 Paris (FR)
(72) Inventeur: Zarudniev, Mykhailo, 04213 KIEV (UA); Colinet, Eric, 76230 BOIS-GUILLAUME (FR); Villard, Patrick, 38700 La Tronche (FR)
(74) Mandataire: Guérin, Michel

(57) **Abrégé**

L'invention concerne les oscillateurs à transfert de spin, appelés en anglais "spin torque oscillators", et plus précisément les oscillateurs à base de jonctions à effet de magnétorésistance géante.

L'oscillateur comprend deux groupes de n (n entier supérieur ou égal à 1) jonctions élémentaires à effet de magnétorésistance géante parcourues par des courants électriques, les jonctions de chacun des deux groupes étant en série et alimentées par un courant principal (l₀) respectif et les tensions aux bornes des groupes étant additionnées pour fournir une tension sur une sortie (S) du circuit oscillant. La tension aux bornes d'une ou plusieurs jonctions d'un premier groupe est appliquée à une première entrée (E1) d'un comparateur de phase (PHC) et la tension aux bornes d'une ou plusieurs jonctions de l'autre groupe est appliquée à une autre entrée (E2) du comparateur de phase, le comparateur de phase fournissant sur deux sorties (S1, S2) des courants secondaires de même amplitude et de signes opposés, qui sont fonction de la différence de phase moyenne entre les tensions appliquées aux entrées, les courants secondaires étant additionnés chacun à un courant principal respectif.

## Description

L'invention concerne les oscillateurs à transfert de spin, appelés en anglais "spin torque oscillators".

Sous cette appellation on englobe en particulier les oscillateurs à base de jonctions à effet de magnétorésistance géante. Une jonction à effet de magnétorésistance géante comprend deux couches minces ferromagnétiques séparées par une couche non magnétique. La couche non magnétique peut être électriquement conductrice et on parle alors de "vanne de spin" ou électriquement isolante et on parle alors de "jonction tunnel". Selon l'orientation parallèle ou antiparallèle de l'aimantation des couches magnétiques, la résistance électrique dans le sens perpendiculaire aux couches peut prendre deux valeurs différentes. Ceci résulte de la plus grande difficulté de passage des électrons pour une orientation magnétique anti-parallèle et d'une plus grande facilité pour l'orientation parallèle.

Dans un champ magnétique, l'une des couches magnétiques d'une telle jonction, parcourue par un courant de densité supérieure à une densité dite critique, est le siège d'une oscillation de son vecteur d'aimantation. Cette oscillation résulte de l'effet de résonance ferromagnétique propre au matériau de cette couche et de l'effet dit de transfert de spin ("spintorque" en anglais) qui assure une compensation des diverses pertes dans le matériau. Sans l'effet de transfert de spin, l'oscillation du vecteur aimantation serait amortie et s'éteindrait progressivement. Entretenue grâce au transfert de spin, l'oscillation peut être détectée par l'effet de magnétorésistance géante. Il est connu de réaliser des oscillateurs à base de jonctions à effet de magnétorésistance géante. Ils peuvent avoir des applications de communications en radiofréquence.

Un des avantages des oscillateurs utilisant une jonction à effet de magnétorésistance géante est le très faible encombrement, la très haute fréquence d'oscillation possible (par exemple de 5 GHz à 20 GHz), et la très large bande de réglage de fréquences d'oscillation possibles (par action sur le courant traversant la jonction).

Mais l'inconvénient principal de ces oscillateurs est la très faible puissance du signal disponible en sortie. Leur stabilité en fréquence n'est par ailleurs pas excellente et ils présentent en général un bruit de phase qu'on préfèrerait ne pas avoir.

On a déjà proposé d'améliorer la fréquence et d'augmenter la puissance du signal de sortie en couplant plusieurs oscillateurs de manière qu'ils fonctionnent en synchronisme les uns avec les autres.

La publication de brevet US 2009/0115541 en donne un exemple. Les jonctions sont couplées par une résistance. On a constaté que le bruit de phase et la résistance aux perturbations de l'oscillation n'étaient pas aussi bons qu'on le souhaiterait. Les perturbations qu'on envisage ici sont les perturbations provenant de l'extérieur de l'oscillateur : par exemple, dans une application à un téléphone portable, les perturbations peuvent provenir des changements d'environnement magnétique ou électrique selon l'endroit où se trouve le téléphone. On veut que l'oscillateur reste synchronisé malgré ces perturbations, ou au moins qu'il converge très vite vers une resynchronisation. L'oscillateur de la publication mentionnée ne permet pas une resynchronisation suffisamment rapide. De plus, si on veut augmenter la puissance de sortie par la mise en synchronisme de plusieurs oscillateurs à très faible puissance, il faut encore que les oscillateurs soient en phase, faute de quoi les signaux ne s'ajoutent pas et peuvent même se soustraire. Les dispositifs de l'art antérieur ne permettent pas de faire correctement cette mise en phase.

Selon l'invention, on propose un circuit oscillant comprenant deux groupes de n (n entier supérieur ou égal à 1) jonctions élémentaires à effet de magnétorésistance géante parcourues par des courants électriques, les jonctions de chacun des deux groupes étant en série et alimentées par des courants principaux respectifs et les tensions alternatives aux bornes des groupes étant additionnées pour fournir une tension sur une sortie du circuit oscillant, caractérisé en ce que la tension aux bornes d'une ou plusieurs jonctions d'un premier groupe est appliquée à une première entrée d'un comparateur de phase et la tension aux bornes d'une ou plusieurs jonctions de l'autre groupe est appliquée à une autre entrée du comparateur de phase, le comparateur de phase fournissant sur deux sorties des courants secondaires de même amplitude et de signes opposés, qui sont fonction de la différence de phase moyenne entre les tensions appliquées aux entrées, les courants secondaires étant additionnés chacun à un courant principal respectif. Le sens de connexion pour effectuer cette addition est le sens qui tend à réduire la différence de phase moyenne à l'entrée du comparateur.

S'il y a plus d'une jonction dans chaque groupe (n au moins égal à 2), la tension appliquée à l'entrée du comparateur de phase peut être la tension aux bornes des n jonctions ou la tension aux bornes d'un nombre de jonctions en série inférieur à n, ce nombre étant toutefois le même pour les deux groupes.

Le comparateur de phase établit une réaction active d'un oscillateur sur l'autre dans un sens tendant à synchroniser les phases des oscillations des deux groupes de jonction. Le bruit de phase de l'oscillation est inférieur à la somme des bruits de phase des oscillateurs individuels du fait que ces bruits de phase ne sont pas corrélés.

Le circuit oscillant peut comprendre en outre deux circuits de conversion tension-courant, chacun recevant la tension aux bornes d'un groupe de jonctions respectif et ayant une sortie reliée à l'autre groupe pour lui injecter un courant qui dépend de la tension aux bornes du premier groupe mentionné. Cette disposition engendre un couplage direct entre les deux jonctions, qui s'ajoute au couplage indirect engendré par le comparateur de phase ; ce couplage agit directement sur la synchronisation des fréquences d'oscillation des oscillateurs. Il facilite l'obtention d'un synchronisme de fréquences en cas de décrochage dû à une perturbation électrique ou magnétique dans l'environnement de l'oscillateur. Il facilite également l'obtention d'un synchronisme malgré les dispersions technologiques possibles entre les jonctions à effet de magnétorésistance géante. Alternativement, on peut prévoir un seul circuit de conversion tension-courant différentiel qui reçoit la différence des tensions aux bornes des deux groupes de jonctions et qui produit deux courants variant en sens inverse en fonction de la différence des tensions, ces courants étant appliqués respectivement à l'un et à l'autre groupe de jonctions.

Le comparateur de phase comprend de préférence un circuit de mise en forme pour transformer en signaux rectangulaires les tensions oscillantes qu'il reçoit, un modulateur de largeur d'impulsion fournissant des impulsions de largeur variable en fonction du déphasage des signaux rectangulaires, un circuit intégrateur recevant les impulsions de largeur variable pour fournir une tension signée proportionnelle au déphasage moyen, et un circuit de conversion tension-courant commandé par le circuit intégrateur pour produire deux courants identiques en valeur absolue et de signes opposés, dont l'amplitude et le signe représentent le déphasage, ces courants constituant les courants de sortie du comparateur de phase, appliqués aux groupes de jonctions.

D'autres caractéristiques et avantages de l'invention apparaîtront à la lecture de la description détaillée qui suit et qui est faite en référence aux dessins annexés dans lesquels :
- la figure 1 représente un schéma électrique de principe de l'invention ;
- la figure 2 représente un schéma d'une variante avec couplage direct entre la tension d'oscillation aux bornes d'une jonction et le courant qui traverse l'autre ;
- la figure 3 représente un schéma dans lequel chaque groupe de jonctions comprend deux jonctions en série ;
- la figure 4 représente un schéma dans lequel chaque groupe de jonctions comprend n jonctions en série, n>2.

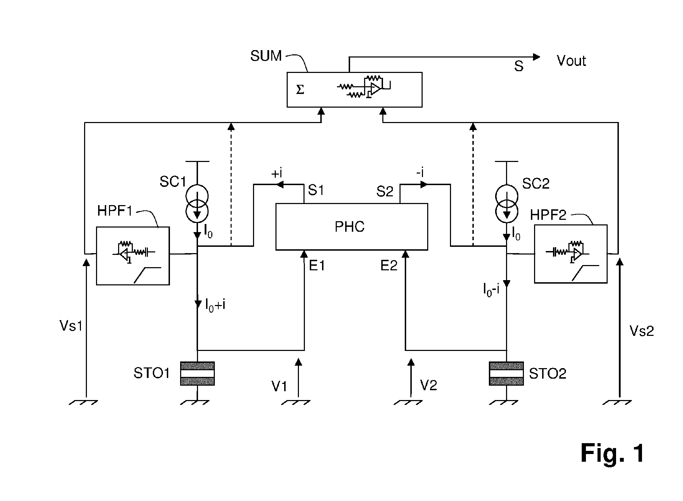

La figure 1 représente un schéma de base du circuit oscillant selon l'invention. Ce schéma ne comporte que deux jonctions à effet de magnétorésistance géante, ST01 et ST02 respectivement. On considère donc ici artificiellement, qu'il y a deux groupes de n jonctions en série mais chaque groupe ne comporte qu'une seule jonction (n=1).

Les jonctions sont constituées typiquement par deux couches minces ferromagnétiques séparées par une couche non magnétique. La couche non magnétique est de préférence électriquement isolante.

La jonction ST01 est alimentée par une source de courant SC1 qui fournit un courant principal de référence l₀ ; on verra qu'un courant secondaire de contre-réaction +i est ajouté au courant principal, de sorte que la jonction ST01 est parcourue par un courant l₀+i ; symétriquement, la jonction ST02 est alimentée par une source de courant SC2 qui fournit un courant principal identique au courant de référence l₀, et elle reçoit en outre un courant secondaire -i identique, mais de signe inverse, au courant secondaire +i appliqué à la jonction ST01. La jonction ST02 est donc parcourue par un courant l₀-i.

Les jonctions ST01 et ST02 sont identiques. Les sources de courant SC1 et SC2 sont également identiques. Les amplitudes et les fréquences d'oscillation des deux jonctions sont donc théoriquement identiques.

Les tensions engendrées aux bornes des jonctions ST01 et ST02 sont V1 et V2, comportant une composante continue et une composante haute fréquence correspondant à la fréquence d'oscillation qu'on souhaite produire avec ce circuit. La composante continue est éliminée par un filtre passe-haut HPF1 relié à la jonction ST1 et HPF2 relié à la jonction ST02. Les tensions haute fréquence filtrées résultant de l'oscillation des jonctions ST01 et ST02 sont appelées Vs1 et Vs2 respectivement. Les filtres passe-haut sont cependant facultatifs.

Ces tensions Vs1 et Vs2 sont additionnées dans un sommateur de tensions SUM pour produire sur une sortie S une tension Vout qui est la tension haute fréquence de sortie du circuit oscillant de la figure 1. Mais si les phases des oscillations des deux jonctions ne sont pas identiques (en supposant que les fréquences sont rigoureusement identiques), la sommation des tensions Vs1 et Vs2 n'aboutit pas à un accroissement optimal de l'amplitude de l'oscillation.

Un comparateur de phase PHC à deux entrées E1 et E2 reçoit respectivement les tensions V1 et V2 aux bornes des deux jonctions. Ce comparateur produit un courant différentiel dont la valeur i, signée, représente le déphasage existant entre les tensions V1 et V2 reçues sur ses entrées.

Le courant différentiel est obtenu en sortie du comparateur, sur deux bornes de sortie S1 et S2 ; la borne S1 produit un courant +i ; la borne S2 produit un courant -i (même amplitude que le courant +i et signe opposé).

Les courants l₀+i et l₀-i des jonctions ST01 et ST02 varient donc en sens inverse l'un de l'autre, ce qui tend à faire varier les fréquences d'oscillations en sens inverse l'une de l'autre. Le sens de connexion des sorties du comparateur est choisi pour que ces variations opposées tendent à stabiliser le courant différentiel i à une valeur qui minimise la différence de phase des oscillations.

Les tensions Vs1 et Vs2 sont alors en phase (les filtres passe-haut étant identiques et n'introduisant pas de différences de phase), et elles peuvent être ajoutées dans le sommateur en optimisant l'addition des amplitudes.

Le comparateur de phase peut être de construction très simple. Il peut comprendre un circuit de mise en forme pour transformer en signaux rectangulaires d'amplitude constante les tensions oscillantes qu'il reçoit ; un simple amplificateur à grand gain peut convenir ; les fronts de montée des signaux rectangulaires définissent alors la phase de la tension oscillante, c'est-à-dire qu'elles représentent le passage de la tension par zéro. Un modulateur de largeur d'impulsion constitué par de simples portes logiques reçoit les deux tensions transformées en signaux rectangulaires et fournit des impulsions de largeur variable en fonction du déphasage des signaux rectangulaires. Un circuit intégrateur recevant les impulsions de largeur variable fournit une tension signée proportionnelle au déphasage moyen. Enfin, un circuit de conversion tension-courant reçoit la sortie du circuit intégrateur et produit deux courants identiques en valeur absolue et de signes opposés, dont l'amplitude et le signe représentent le déphasage. Ces deux courants constituent les courants de sortie du comparateur de phase, appliqués aux groupes de jonctions.

On notera qu'au lieu d'additionner les tensions électriques Vs1 et Vs2 dans le sommateur SUM, on peut additionner les tensions V1 et V2 non filtrées. Cette possibilité d'addition de V1 et V2 est représentée par des connexions en traits tiretés sur la figure 1.

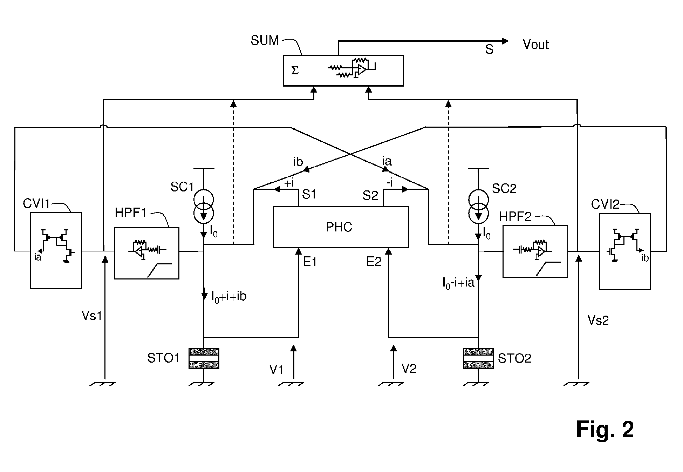

La figure 2 représente un perfectionnement du circuit oscillant de la figure 1. Dans cette variante, on prévoit que l'asservissement de phase par le comparateur de phase est complété par une deuxième boucle de réaction par laquelle la tension oscillante aux bornes de chaque jonction est convertie par un convertisseur tension-courant respectif qui produit un courant qu'on réinjecte dans l'autre jonction. Cette influence croisée d'une jonction vers l'autre agit dans le sens d'une synchronisation des fréquences naturelles des deux oscillateurs. L'ajustement des phases par l'action du comparateur de phases en est facilité en présence d'une perturbation : la synchronisation des fréquences par les convertisseurs accélère le retour à un régime synchronisé en fréquence et en phase. La perturbation peut être un changement de l'environnement magnétique, par exemple dans une application où l'oscillateur fournit une fréquence de référence pour un téléphone portable : le téléphone portable est par essence soumis à des variations très fréquentes et très importantes de l'environnement et il faut que les conséquences d'une perturbation sur la fréquence de référence soient éliminées aussi rapidement que possible.

Sur la figure 2, les éléments de la figure 1 ont été repris et portent les mêmes références qu'à la figure 1. Ils ne seront pas décrits à nouveau. La réinjection est faite de la manière suivante : un convertisseur tension-courant CVI1 (pour les tensions haute fréquence) est connecté à la sortie du filtre passe-haut FPH1. Il produit un courant continu ia proportionnel à l'amplitude de la tension d'oscillation Vs1. Ce courant est appliqué à la jonction ST02 et vient s'ajouter au courant l₀ et au courant éventuel -i produit par le comparateur de phase. Le courant dans cette jonction est alors l₀ -i + ia. De la même manière, un convertisseur tension-courant CVI2 produit un courant continu ib proportionnel à l'amplitude de la tension Vs2. Ce courant est appliqué à la jonction ST01 et vient s'ajouter au courant l₀ et au courant éventuel +i produit par le comparateur de phase. Le courant dans cette jonction est alors l₀ +i + ib.

Le courant qui traverse chaque jonction comporte donc un facteur proportionnel à la tension résultant de l'oscillation de l'autre jonction. Cette influence croisée contribue à la stabilisation de la fréquence commune d'oscillation des jonctions. Le gain de la boucle de réaction est inférieur à 1, c'est-à-dire qu'une variation de tension d'oscillation d'une jonction induit une variation de courant qui elle-même induit dans l'autre jonction une variation de tension d'oscillation inférieure à la première.

Les convertisseurs tension-courant peuvent être constitués simplement par un transistor de commande NMOS et un miroir de courant PMOS. Le transistor de commande reçoit sur sa grille la tension à convertir et il est chargé par un transistor PMOS monté en diode (drain et grille reliés ensemble) ; le courant de la charge est fonction de la tension appliquée . Le courant de charge est recopié par un autre transistor PMOS qui a sa grille et sa source reliées respectivement à la grille et à la source du premier transistor PMOS. Il produit sur son drain un courant ia ou ib qui est fonction de la tension d'entrée Vs1 ou Vs2.

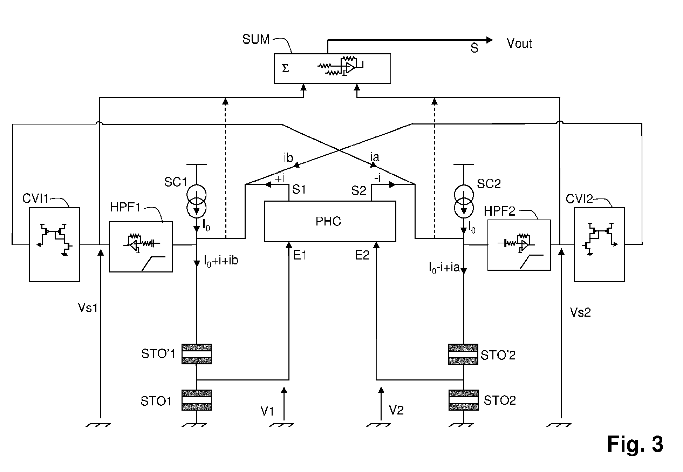

La figure 3 représente un circuit oscillant qui comporte deux groupes de deux jonctions en série. Les éléments communs à ceux des figures 1 et 2 sont repris et les fonctions de ces éléments ne seront pas redécrites. Le premier groupe de jonctions comprend la jonction ST01 en série avec une jonction identique STO'1, l'ensemble étant alimenté par la somme des courants l₀ (de la source de courant SC1), +i (du comparateur de phase), et ib (du convertisseur tension-courant CVI2). Le deuxième groupe de jonctions comprend la jonction ST02 en série avec une jonction identique STO'2, l'ensemble étant alimenté par la somme des courants l₀ (de la source de courant SC2), -i (du comparateur de phase), et ia (du convertisseur tension-courant CVI1).

Les entrées E1 et E2 du comparateur de phase peuvent être prises soit aux bornes des jonctions ST01 et ST02 (comme aux figures 1 et 2) soit aux bornes des groupes en série, c'est-à-dire que l'entrée E1 recevrait dans ce cas une tension V1+V'1 si on appelle V1 la tension aux bornes de ST01 et V'1 la tension aux bornes de STO'1. De même, l'entrée E2 recevrait symétriquement une tension V2+V'2.

La liaison de contre-réaction par les convertisseurs CVI1 et CVI2 utilise sur la figure 3 la tension V1 +V'1 appliquée à l'entrée du convertisseur CVI1 et la tension V2+V'2 appliquée à l'entrée du convertisseur CVI2 ; elle utilise donc la tension aux bornes des groupes de deux jonctions en série ; mais on pourrait aussi prévoir d'appliquer à l'entrée de ces convertisseurs la tension aux bornes d'une seule jonction, respectivement ST01 ou ST02.

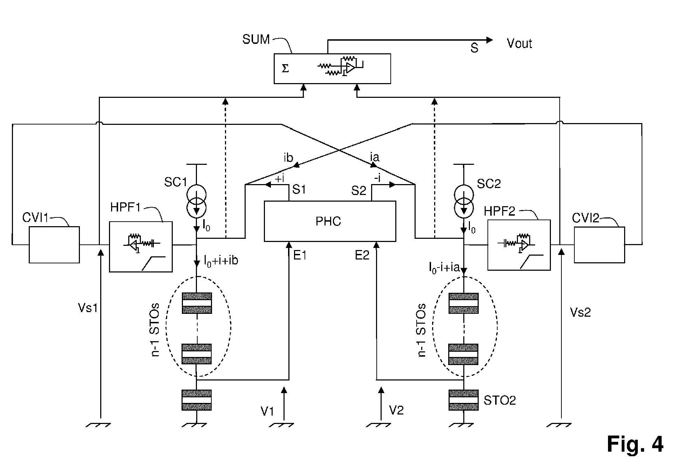

La figure 4 représente encore une autre réalisation dans laquelle les jonctions à effet de magnétorésistance géante sont plus nombreuses et agencées en deux groupes de n jonctions, n supérieur à 2. Les éléments de la figure 4 sont les mêmes qu'à la figure 3 mais on voit qu'on a deux ensembles de jonctions en série. Les tensions Vs1 et Vs2 aux bornes des deux ensembles (après filtrage passe-haut) sont additionnées dans le sommateur SUM. La contre-réaction par les convertisseurs tension-courant est faite à partir de ces tensions Vs1 et Vs2 mais elle pourrait être faite à partir de tensions prises aux bornes d'un nombre n' (n'<n) de jonctions, à condition que n' soit le même pour les deux ensembles.

De même, la contre-réaction par le comparateur de phase utilise sur la figure 4 la tension aux bornes d'une seule jonction (ST01, ST02) mais elle pourrait utiliser la tension aux bornes de plusieurs jonctions en série ou même toutes les jonctions en série, à condition que ce soit le même nombre pour les deux groupes de jonction en série.

## Revendications

1. Circuit oscillant comprenant deux groupes de n (n entier supérieur ou égal à 1) jonctions élémentaires à effet de magnétorésistance géante parcourues par des courants électriques, les jonctions de chacun des deux groupes étant en série et alimentées par des courants principaux (l₀) respectifs et les tensions aux bornes des groupes étant additionnées pour fournir une tension sur une sortie (S) du circuit oscillant, **caractérisé en ce que** la tension aux bornes d'une ou plusieurs jonctions d'un premier groupe est appliquée à une première entrée (E1) d'un comparateur de phase (PHC) et la tension aux bornes d'une ou plusieurs jonctions de l'autre groupe est appliquée à une autre entrée (E2) du comparateur de phase, le comparateur de phase fournissant sur deux sorties (S1, S2) des courants secondaires de même amplitude et de signes opposés, qui sont fonction de la différence de phase moyenne entre les tensions appliquées aux entrées, les courants secondaires étant additionnés chacun à un courant principal respectif.

2. Circuit oscillant selon la revendication 1, **caractérisé en ce que** le comparateur de phase comprend un circuit de mise en forme pour transformer en signaux rectangulaires les tensions oscillantes qu'il reçoit, un modulateur de largeur d'impulsion fournissant des impulsions de largeur variable en fonction du déphasage des signaux rectangulaires, un circuit intégrateur recevant les impulsions de largeur variable pour fournir une tension signée proportionnelle au déphasage moyen, et un circuit de conversion tension-courant commandé par le circuit intégrateur pour produire deux courants (+i, -i) identiques en valeur absolue et de signes opposés, dont l'amplitude et le signe représentent le déphasage, ces courants constituant les courants de sortie du comparateur de phase, appliqués aux groupes de jonctions.

3. Circuit oscillant selon l'une des revendications 1 et 2, **caractérisé en ce qu'**il comprend en outre deux circuits de conversion tension-courant (CVI1, CVI2), recevant chacun la tension aux bornes d'un groupe de jonctions respectif et ayant une sortie reliée à l'autre groupe pour lui injecter un courant (ia, ib) qui dépend de la tension aux bornes du premier groupe mentionné.

4. Circuit oscillant selon la revendication 3, **caractérisé en ce que** les circuits de conversion tension-courant qui reçoivent la tension aux bornes d'un groupe de jonctions comprennent chacun un transistor recevant sur sa grille la sortie en tension du groupe, pour produire dans le transistor un courant fonction de la tension appliquée à la grille, et un miroir de courant pour recopier le courant dans le transistor, la sortie du miroir de courant constituant la sortie du circuit de conversion, reliée à l'autre groupe de jonctions.

5. Circuit oscillant selon l'une des revendications 1 à 4, **caractérisé en ce que** n est égal à 1, chaque groupe comprenant une seule jonction.

6. Circuit oscillant selon l'une des revendications 1 à 4, **caractérisé en ce que** n est supérieur à 1 et **en ce que** la tension appliquée à l'entrée du comparateur de phase est la tension aux bornes d'un nombre de jonctions en série inférieur à n, ce nombre étant le même pour les deux groupes.

7. Circuit oscillant selon l'une des revendications 1 à 4, **caractérisé en ce que** n est supérieur à 1 et **en ce que** la tension appliquée à l'entrée du comparateur de phase est la tension aux bornes d'un nombre de jonctions en série égal à n pour les deux groupes.

8. Circuit oscillant selon l'une des revendications 1 à 7, **caractérisé en ce que** les jonctions sont constituées chacune par deux couches ferromagnétiques séparées par une couche électriquement isolante très mince et placées dans un champ magnétique.
